# EUROPEAN PATENT APPLICATION

(11) **EP 4 664 102 A1**
(43) Date of publication of application: **17.12.2025**
(21) Application number: 24829712.9
(22) Date of filing: 05.01.2024
(51) Int. Cl.: G01N 23/04

(54) **BATTERY DEFECT DETECTION DEVICE, DETECTION METHOD AND STORAGE MEDIUM**

(30) Priority: 30.06.2023 CN 202310797723
(71) Applicant: Contemporary Amperex Technology Co., Limited, Ningde, Fujian 352100 (CN)
(72) Inventor: PAN, Wensheng, Ningde, Fujian 352100 (CN); HUANG, Dengdeng, Ningde, Fujian 352100 (CN); HUANG, Qinkun, Ningde, Fujian 352100 (CN); YANG, Mukai, Ningde, Fujian 352100 (CN); FAN, Xiang, Ningde, Fujian 352100 (CN)
(74) Representative: Lorenz Seidler Gossel Part. mbB
(86) International application number: PCT/CN2024/070911
(87) International publication number: WO 2025/001049

(57) **Abstract**

The present application provides a battery defect detection device, a detection method and a storage medium. The battery defect detection device comprises a ray source, a detector, a bearing part, a moving mechanism and a defect detection unit; the moving mechanism is used for adjusting, in a direction parallel to a battery bearing surface, relative positions between the bearing part and the ray source as well as between the bearing part and the detector, such that optical axes of rays emitted by the ray source vertically project to a plurality of target positions on the surface of a battery, respectively; the detector receives the rays penetrating through the battery so as to obtain a plurality of initial images; the defect detection unit is connected to the detector, and the defect detection unit is used for splicing the plurality of initial images so as to obtain a detection image comprising the whole battery, and performing defect detection on the battery on the basis of the detection image.

## Description

### CROSS-REFERENCE

The present application refers to Chinese Patent Application No. 202310797723.8, entitled "BATTERY DEFECT DETECTION DEVICE AND DETECTION METHOD, AND STORAGE MEDIUM", filed on June 30, 2023, which is incorporated herein by reference in its entirety.

### TECHNICAL FIELD

The present application relates to the technical field of batteries, and in particular, to a battery defect detection method and detection apparatus, a device, a medium, and a product.

### BACKGROUND

Energy conservation and emission reduction are the key to sustainable development of the automobile industry. Electric vehicles have become an important part of the sustainable development of the automobile industry due to their energy-saving and environmental protection advantages. For electric vehicles, the battery technology is an important factor in their development.

Since the safety and reliability of a battery are of great importance, it is necessary to implement strict and comprehensive control over potential defects during battery production, including the detection of defects such as internal wrinkles, folded corners, and electrode plate damage of the battery. Defect detection based on battery images has been applied more widely, but the detection effect is yet to be improved due to the impact of imaging quality.

### SUMMARY

The present application aims to solve at least one of the technical problems existing in the background. Therefore, an objective of the present application is to provide a battery defect detection device and detection method, an electronic device, a storage medium, and a computer program product, so as to improve the battery defect detection effect.

Embodiments of a first aspect of the present application provide a battery defect detection device. The battery defect detection device includes: a ray source; a detector; a carrying component including a carrying surface configured to carry a battery; a moving mechanism configured to adjust, in a direction parallel to the carrying surface, relative positions of the carrying component relative to the ray source and the detector, such that optical axes of rays emitted by the ray source are vertically projected onto a plurality of target positions on a battery surface, respectively, and the detector receives the rays penetrating through the battery to obtain a plurality of initial images; and a defect detection unit connected to the detector, where the defect detection unit is configured to stitch the plurality of initial images to obtain a detection image including the entire battery, and to perform defect detection on the battery based on the detection image.

In the technical solution of the embodiments of the present application, the relative positions of the carrying component relative to the ray source and the detector are adjusted by the moving mechanism in the direction parallel to the carrying surface of the battery, such that the optical axes of the rays emitted by the ray source are vertically projected onto the plurality of positions on the battery surface, respectively, and the detection image of the entire battery is obtained by stitching the images captured at the plurality of positions, thereby reducing the impact of image distortion at the edge of the battery, achieving effective battery defect detection, and improving the battery defect detection effect.

In some embodiments, the detector is a flat panel detector with a high spatial resolution, which can clearly display fine structures and variations and is beneficial to improving the accuracy of battery defects.

In some embodiments, a dimension of a radiation surface of the ray source on a plane where the carrying surface is located is greater than a preset value. Therefore, the radiation surface of the ray source on the plane where the battery surface is located is large enough, which further mitigates the problem of distortion at the edge of the battery in the captured image to improve the detection effect, and reduces the number of captures to improve the detection efficiency.

In some embodiments, the plurality of target positions include a first preset point on each of two opposite side edges of the battery. Since the plurality of target positions include the first preset point on each of the two opposite side edges of the battery, the problem of distortion at the edge of the battery can be solved more effectively.

In some embodiments, the plurality of target positions further include at least one second preset point on a connecting line between two of the first preset points on the two opposite side edges of the battery. By obtaining the initial images at the two first preset points and the at least one second preset point, it can be ensured that the detection image including the entire battery can be obtained, thereby implementing comprehensive defect detection on the battery and improving the accuracy of battery defect detection.

In some embodiments, the first preset point is a midpoint on each of the side edges, such that the obtained initial image is symmetrical about the midpoint, which avoids the problem of distortion at one end of the side edge of the battery, thereby improving the battery defect detection efficiency, and also avoids a need for multiple captures at the side edge, which may occur if the first preset point deviates from the midpoint, to obtain the detection image including the entire battery.

In some embodiments, the detector is a time delay integration detector. The detection image including the entire battery is acquired by the time delay integration detector, which can better overcome the problem of image distortion at the edge of the battery and improve the quality of the detection image of the battery, thereby improving the battery defect detection effect.

In some embodiments, the rays emitted by the ray source scan the battery surface in a direction parallel to a side edge of the battery, and the plurality of target positions include a plurality of scanning positions of an optical axis of the ray source on the battery surface. Scanning the battery surface by the ray source can effectively solve the problem of distortion at the edge of the battery and improve the quality of the obtained detection image of the battery, which is further beneficial to more accurate battery defect detection and improving the accuracy of detection results.

In some embodiments, the moving mechanism is configured to drive the carrying component to move in the direction parallel to the carrying surface, so as to adjust the relative positions of the carrying component relative to the ray source and the detector. The moving mechanism drives the carrying component to move in the direction parallel to the battery surface, so as to adjust the relative positions of the carrying component relative to the ray source and the detector, such that the optical axis of the ray emitted by the ray source is vertically projected onto the battery surface at each target position, thereby mitigating the problem of distortion at the edge of the battery and improving the battery defect detection effect.

In some embodiments, the moving mechanism is configured to drive the ray source and the detector to move in the direction parallel to the carrying surface, so as to adjust the relative positions of the carrying component relative to the ray source and the detector, such that the optical axis of the ray emitted by the ray source is vertically projected onto the battery surface at each target position, thereby mitigating the problem of image distortion at the edge of the battery and improving the battery defect detection effect.

Embodiments of a second aspect of the present application provide a battery defect detection method. The battery defect detection method includes: acquiring, by a detector, a plurality of initial images captured by vertically projecting optical axes of rays emitted by a ray source onto a plurality of target positions on a battery surface, respectively; stitching the plurality of initial images to obtain a detection image including the entire battery; and performing defect detection on the battery based on the detection image.

The initial images captured by vertically projecting the optical axes of the rays emitted by the ray source respectively onto the plurality of target positions on the battery surface are acquired by the detector, thereby mitigating the problem of image distortion at the edge of the battery and improving the battery defect detection effect. In addition, the detection image including the entire battery is obtained by stitching the plurality of initial images, such that defect detection can be performed on the entire battery, thereby improving the accuracy and comprehensiveness of battery defect detection.

In some embodiments, the detector is a flat panel detector, and a dimension of a radiation surface of the ray source on a plane where the carrying surface is located is greater than a preset value. Therefore, the radiation surface of the ray source on the plane where the battery surface is located is large enough, which further mitigates the problem of distortion at the edge of the battery in the captured image to improve the detection effect, and reduces the number of captures to improve the detection efficiency.

In some embodiments, the plurality of target positions include a first preset point on each of two opposite side edges of the battery, the plurality of initial images include a first initial image and a second initial image, and the first initial image and the second initial image are captured by using the following method: vertically projecting an optical axis of a ray emitted by the ray source onto the first preset point on one of the two opposite side edges, such that the detector receives the ray penetrating through the battery to obtain the first initial image; and vertically projecting an optical axis of a ray emitted by the ray source onto the first preset point on the other of the two opposite side edges, such that the detector receives the ray penetrating through the battery to obtain the second initial image. Since the plurality of target positions include the first preset point on each of the two opposite side edges of the battery, the problem of distortion at the edge of the battery can be solved more effectively.

In some embodiments, the plurality of target positions include at least one second preset point on a connecting line between two of the first preset points on the two opposite side edges of the battery, the plurality of initial images include at least one third initial image, and the at least one third initial image is captured by using the following method: vertically projecting an optical axis of a ray emitted by the ray source onto each of the at least one second preset point, respectively, such that the detector receives the ray penetrating through the battery to obtain the third initial image. By obtaining the initial images at the two first preset points and the at least one second preset point, it can be ensured that the detection image including the entire battery can be obtained, thereby implementing comprehensive defect detection on the battery and improving the accuracy of battery defect detection.

In some embodiments, the detector is a time delay integration detector, and the plurality of initial images being captured by using the following method includes: scanning the battery surface by the rays emitted by the ray source in a direction parallel to a side edge of the battery, such that the detector receives the rays penetrating through the battery to obtain the plurality of initial images, where the plurality of target positions include a plurality of scanning positions of an optical axis of the ray source on the battery surface. The detection image including the entire battery is acquired by the time delay integration detector, which can better overcome the problem of image distortion at the edge of the battery and improve the quality of the detection image of the battery, thereby improving the battery defect detection effect.

In some embodiments, the battery defect detection method further includes: rejecting or retesting the battery in response to a failure in a detection result of the battery, so as to improve the accuracy and detection efficiency of battery defect detection.

Embodiments of a third aspect of the present application provide a battery defect detection apparatus. The apparatus includes: an acquiring module configured to acquire a plurality of initial images captured by vertically projecting optical axes of rays emitted by a ray source onto a plurality of target positions on a battery surface, respectively; a stitching module configured to stitch the plurality of initial images to obtain a detection image including the entire battery; and a detecting module configured to perform defect detection on the battery based on the detection image.

The detection image is obtained based on the plurality of initial images captured by vertically projecting the optical axes of the rays emitted by the ray source onto the plurality of target positions on the battery surface, respectively, thereby mitigating the problem of image distortion at the edge of the battery and improving the battery defect detection effect. In addition, the detection image including the entire battery is obtained by stitching the plurality of initial images, such that defect detection can be performed on the entire battery, thereby improving the accuracy and comprehensiveness of battery defect detection.

Embodiments of a fourth aspect of the present application provide a battery production system. The battery production system includes the battery detection device according to any one of the foregoing embodiments.

Embodiments of a fifth aspect of the present application provide an electronic device. The electronic device includes: at least one processor; and a memory communicatively connected to the at least one processor, where the memory stores instructions executable by the at least one processor, and the instructions, when executed by the at least one processor, enable the at least one processor to perform the battery defect detection method according to any one of the foregoing embodiments.

Embodiments of a sixth aspect of the present application provide a computer-readable storage medium. The computer-readable storage medium stores a computer program that, when executed by a processor, implements the battery defect detection method according to any one of the foregoing embodiments.

Embodiments of a seventh aspect of the present application provide a computer program product. The computer program product includes a computer program that, when executed by a processor, implements the battery defect detection method according to any one of the foregoing embodiments.

The above description is only an overview of the technical solutions of the present application. To more clearly understand the technical means of the present application to enable implementation in accordance with the content of the specification and to make the above and other purposes, features, and advantages of the present application more obvious and easy to understand, the detailed description of the present application is provided below.

### BRIEF DESCRIPTION OF THE DRAWINGS

In the accompanying drawings, unless otherwise specified, the same reference numerals across multiple accompanying drawings indicate the same or similar components or elements. The accompanying drawings are not necessarily drawn to scale. It should be understood that the accompanying drawings depict only some embodiments of the present application and are therefore not to be considered as limiting the scope of the present application.
FIG. 1 is a schematic diagram of a battery defect detection device in the related art;
FIG. 2 is a schematic structural diagram of a battery defect detection device according to some embodiments of the present application;
FIG. 3 is a front view of the battery defect detection device in FIG. 2;
FIG. 4 is a top view of the battery defect detection device in FIG. 2;
FIG. 5 is a left side view of the battery defect detection device in FIG. 2;
FIG. 6 is a schematic structural diagram of another battery defect detection device according to some embodiments of the present application;
FIG. 7 is a top view of another battery defect detection device according to some embodiments of the present application;
FIG. 8 is a schematic structural diagram of another battery defect detection device according to some embodiments of the present application;
FIG. 9 is a schematic structural diagram of another battery defect detection device according to some embodiments of the present application;
FIG. 10 is a schematic structural diagram of still another battery defect detection device according to some embodiments of the present application;
FIG. 11 is a flowchart of a battery defect detection method according to some embodiments of the present application;
FIG. 12 is a flowchart of another battery defect detection method according to some embodiments of the present application; and
FIG. 13 is a block diagram illustrating the composition of a battery defect detection apparatus according to some embodiments of the present application.

Description of the reference numerals:
1000: defect detection device;
100: ray source; 101: optical axis; 102: radiation cross section; 103: ray;
200: detector; 300: carrying component; 400: moving mechanism; 410: fixing support; 420: lead screw; 430: threaded sleeve;
500: defect detection unit;
600: battery; 601: first preset point; 602: second preset point; 603: battery surface; 61: distorted region;
2000: defect detection apparatus;
2001: acquiring module; 2002: stitching module; 2003: detecting module.

### DETAILED DESCRIPTION

Embodiments of the technical solutions of the present application will be described in detail below with reference to the drawings. The following embodiments are only used to more clearly illustrate the technical solutions of the present application, and therefore, are only exemplary and do not limit the claimed scope of the present application.

Unless otherwise defined, all technical and scientific terms used herein have the same meaning as commonly understood by those skilled in the technical field to which the present application belongs. The terms used herein are only used to illustrate the specific embodiments, rather than limit the present application. The terms "include", "comprise", and "provided with", and any variations thereof in the description and claims of the present application and the above drawing description encompass non-exclusive inclusions.

In the description of the embodiments of the present application, technical terms such as "first" and "second" are only used to distinguish different objects and should not be interpreted as indicating or implying the relative importance or implicitly indicating the number, specific order, or primary and secondary relationship of the noted technical features. In the description of the embodiments of the present application, unless otherwise specifically defined, "plurality of" means two or more.

Reference in the present application to "embodiment" means that a particular feature, structure, or characteristic described in combination with the embodiment can be included in at least one embodiment of the present application. The references of the word in the context of the specification do not necessarily refer to the same embodiment, nor to separate or alternative embodiments exclusive of other embodiments. It will be explicitly and implicitly appreciated by those skilled in the art that the embodiments described herein can be combined with other embodiments.

In the description of the embodiments of the present application, the term "and/or" is merely a way to describe the associative relationship between associated objects, indicating that there are three possible relationships. For example, "A and/or B" may denote: the presence of A alone, the simultaneous presence of A and B, and the presence of B alone. In addition, the character "/" herein generally indicates an "or" relationship between the associated objects before and after the "/".

In the description of the embodiments of the present application, the term "plurality of" refers to two or more (including two). Similarly, "plurality of groups" refers to two or more (including two) groups, and "plurality of pieces" refers to two or more (including two) pieces.

In the description of the embodiments of the present application, the technical terms "center", "longitudinal", "transverse", "length", "width", "thickness", "upper", "lower", "front", "rear", "left", "right", "vertical", "horizontal", "top", "bottom", "inner", "outer", "clockwise" "counterclockwise", "axial", "radial", "circumferential" and the like indicate orientations or positional relationships based on those shown in the drawings. They are merely for the convenience of describing the embodiments of the present application and simplifying the description, rather than indicating or implying that the apparatus or element referred to must have a specific orientation or be constructed and operated in the specific orientation, and thus should not be construed as a limitation to the embodiments of the present application.

In the description of the embodiments of the present application, unless otherwise clearly specified and defined, the technical terms "mount", "interconnect", "connect", "fix", and the like should be interpreted in their broad senses. For example, they may be a fixed connection, a detachable connection, or an integral connection; a mechanical connection or an electrical connection; or a direct connection, an indirect connection via an intermediate, a communication between interiors of two elements, or an interaction between two elements. For those of ordinary skill in the art, the specific meanings of the above terms in the embodiments of the present application can be interpreted according to specific conditions.

At present, judging from the trends in the market, the application of power batteries is becoming increasingly widespread. Power batteries are not only applied in energy storage power systems such as hydropower, thermal power, wind power, and solar power stations, but also widely applied in electric transportation vehicles such as electric bicycles, electric motorcycles, or electric cars, as well as in military equipment, aerospace, and other fields. With the continuous expansion of the application field of power batteries, the market demand for power batteries is also constantly increasing.

Since the safety and reliability of a battery are of great importance, it is necessary to implement strict and comprehensive control over potential defects during battery production, including the detection of defects such as internal wrinkles, folded corners, and electrode plate damage of the battery. Defect detection based on battery images has been applied more widely, but the detection effect is yet to be improved due to the impact of imaging quality. In the related art, a detection image of the battery may be acquired by using a ray, and the defect detection may be performed on the battery based on the detection image, thereby detecting potential defects during the production, such as internal wrinkles, folded corners, and electrode plate damage of the battery.

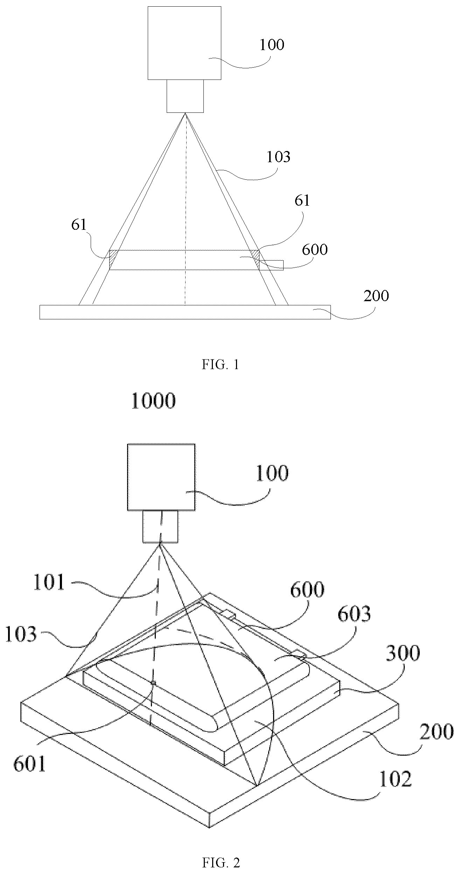

FIG. 1 is a schematic diagram of a battery defect detection device in the related art. Rays 103 form distorted regions 61 at edges of a battery. As shown in FIG. 1, when the battery defect detection device in the related art performs defect detection, the rays 103 emitted by a ray source 100 form a conical beam, and the detector 200 receives the rays 103 penetrating through the battery 600 to obtain a detection image of the battery 600. However, due to inconsistent transmission thicknesses for the rays 103 at the edges of the battery 600, the obtained detection image exhibits distortion. The defect detection on the battery based on the detection image may generate a poor battery defect detection effect in the distorted regions 61, which affects the accuracy of the defect detection at the edges of the battery, resulting in the inability to fully guarantee the quality of the battery.

The battery defect detection device and detection method disclosed in the embodiments of the present application can effectively detect defects such as internal wrinkles, folded corners, and electrode plate damage of a battery, reduce the outflow of risky batteries, and improve the reliability and safety of batteries.

Embodiments of the present application provide a battery defect detection device and detection method, an electronic device, a storage medium, and a computer program product, which can be applied to, without limitation, cylindrical batteries, pouch batteries, square-shell batteries, wound batteries, and the like.

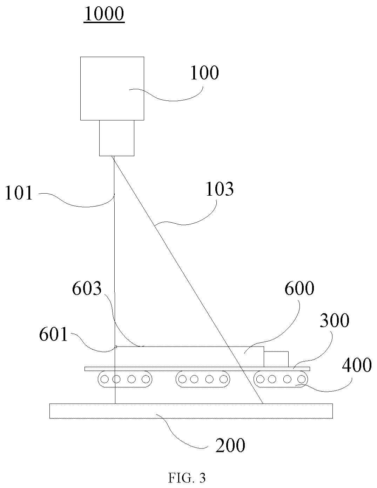

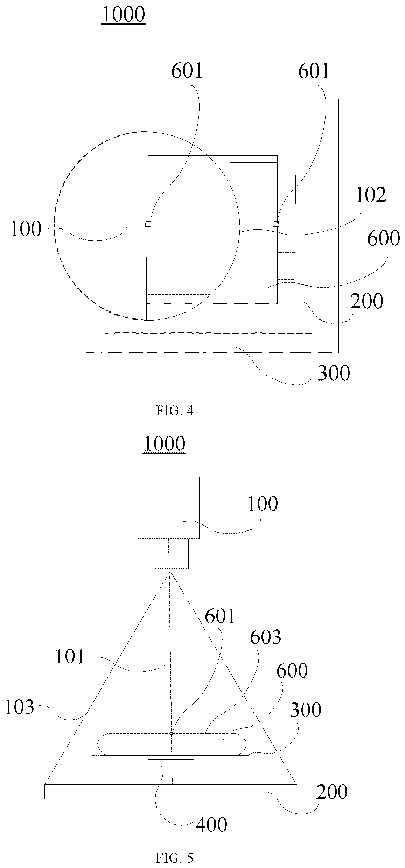

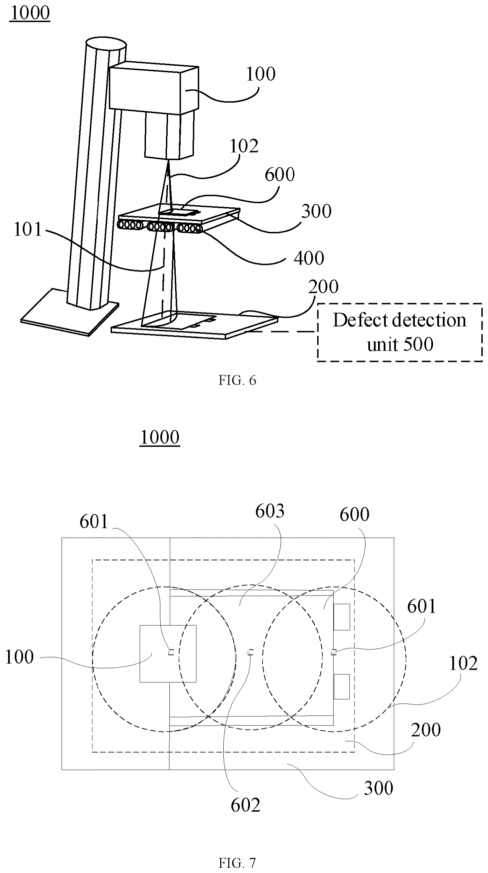

FIG. 2 is a schematic structural diagram of a battery defect detection device according to some embodiments of the present application. FIG. 3 is a front view of the battery defect detection device in FIG. 2. FIG. 4 is a top view of the battery defect detection device in FIG. 2. FIG. 5 is a left view of the battery defect detection device in FIG. 2. FIG. 6 is a schematic structural diagram of another battery defect detection device according to some embodiments of the present application. FIG. 7 is a top view of another battery defect detection device according to some embodiments of the present application.

As shown in FIGs. 2-7, the embodiments of the present application provide a battery defect detection device 1000. The battery defect detection device includes a ray source 100, a detector 200, a carrying component 300, a moving mechanism 400, and a defect detection unit 500. The carrying component 300 includes a carrying surface configured to carry a battery 600. The moving mechanism 400 is configured to adjust, in a direction parallel to the carrying surface, relative positions of the carrying component 300 relative to the ray source 100 and the detector 200, such that optical axes 101 of rays emitted by the ray source 100 are vertically projected onto a plurality of target positions on a battery surface 603, respectively. The detector 200 receives the rays penetrating through the battery 600 to obtain a plurality of initial images. The defect detection unit 500 is connected to the detector 200. The defect detection unit 500 is configured to stitch the plurality of initial images to obtain a detection image including the entire battery 600, and to perform defect detection on the battery 600 based on the detection image.

The battery 600 may be placed on the carrying surface of the carrying component 300. According to some embodiments of the present application, the carrying component 300 and the battery 600 may be driven by the moving mechanism 400 to move in the direction parallel to the carrying surface. When the optical axis 101 of the ray emitted by the ray source 100 is vertically projected onto a target position on the battery surface 603, the moving mechanism 400 pauses its movement. At this point, the ray source 100 emits a ray 103 to the battery 600, and the detector 200 receives the corresponding ray penetrating through the battery 600 at the target position, to obtain a corresponding initial image at the target position. After the detector 200 completes acquiring the corresponding initial image at the target position, the moving mechanism 400 moves again, such that the optical axis 101 of the ray emitted by the ray source 100 is vertically projected onto another target position on the surface of the battery 600. At this point, the ray source 100 emits a ray 103 to the battery 600, and the detector 200 further receives the corresponding ray penetrating through the battery 600 at the other target position. According to some embodiments of the present application, the defect detection unit 500 stitches the obtained plurality of initial images to obtain the detection image including the entire battery 600. The defect detection unit 500 performs the defect detection on the battery 600 based on the detection image.

The number of the plurality of target positions is at least two, and the number of the target positions is related to the detector 100, the dimension and model of the battery 600, and the dimension of a radiation surface of the ray source on the battery surface 603. For example, when the dimension of the battery 600 is large or the detection radius of the detector 100 is small, three or more captures may be sequentially performed in the direction parallel to the battery surface 603 (sequentially from one side to the other side of the battery), so as to obtain the detection image including the entire battery 600.

For example, the moving mechanism 400 moves the battery 600 on the carrying component 300, such that the optical axis 101 of the ray emitted by the ray source 100 directly faces a side edge of the battery 600 (see FIG. 3) and is vertically projected onto the battery surface 603, and the detector 200 obtains an initial image of the battery 600 at the side. Then, the moving mechanism 400 moves the carrying component 300 in the direction parallel to the battery surface 603 to drive the battery 600 on the carrying component 300 to move, such that the optical axis 101 of the ray emitted by the ray source 100 directly faces another side edge of the battery 600 and is vertically projected onto the battery surface 603, and the detector 200 obtains another initial image of the battery 600. The defect detection unit 500 connected to the detector 200 stitches the plurality of initial images to obtain the detection image including the entire battery 600, and performs the defect detection on the battery 600 based on the detection image. In some embodiments, when the radiation surface of the ray source 100 on the battery surface 603 is circular, the radius of the radiation surface may be greater than half of the height of the battery 600, such that when two sides of the battery 600 are captured, the detection image including the entire battery 600 can be obtained based on two captured initial images. In other embodiments, when the radiation surface of the ray source 100 on the battery surface 603 is rectangular, the length or width of the radiation surface may be greater than half of the height of the battery 600, such that when two sides of the battery 600 are captured, the detection image including the entire battery 600 can also be obtained based on two captured initial images. The height of the battery may refer to a distance extending from one side edge to the other opposite side edge of the battery. The detection dimension may refer to the dimension of the radiation surface of the ray emitted by the ray source 100 on a plane where the battery surface 603 is located. It should be noted that the radiation surface of the ray source 100 on the battery surface 603 is not limited to being circular or rectangular, but may also be elliptical, for example.

It should be understood that, as shown in FIG. 1, in the battery defect detection technology in the related art, when the battery 600 moves to a detection station, the ray 103 is aligned with a major surface (a central position) on the battery surface 603. The ray 103 forms a conical beam, and the projection thickness of the conical beam at the edge of the battery 600 is different, resulting in distortion. However, in the battery defect detection device 1000 according to the embodiments of the present application, under the drive of the moving mechanism 400, the relative positions of the carrying component 300 relative to the ray source 100 and the detector 200 are adjusted, such that the optical axes 101 of the rays emitted by the ray source 100 are vertically projected onto the plurality of positions on the battery surface 603, respectively. The plurality of initial images acquired at the plurality of positions are stitched to obtain the detection image including the entire battery 600, thereby reducing the risk of image distortion at the edge of the battery and improving the battery defect detection effect.

The relative positions of the carrying component 300 relative to the ray source 100 and the detector 200 are adjusted by the moving mechanism 400 in the direction parallel to the carrying surface of the battery, such that the optical axes 101 of the rays emitted by the ray source 100 are vertically projected onto the plurality of target positions on the battery surface 603, respectively, and the detection image of the entire battery is obtained by stitching the images captured at the plurality of positions, thereby reducing the impact of image distortion at the edge of the battery, achieving effective battery defect detection, and improving the battery defect detection effect.

According to some embodiments of the present application, the detector 200 is a flat panel detector.

An optical axis 101 of a ray emitted by the ray source 100 directly faces one side edge of the battery 600, with the optical axis 101 being parallel to an end surface at a side of the battery 600. In this case, only half of a conical beam formed by the ray 103 emitted by the ray source 100 is projected onto the battery 600 on the carrying component 300 (see FIG. 4). The flat panel detector receives the ray penetrating through the battery 600 to obtain the corresponding initial image at the side edge, i.e., the initial image captured by vertically projecting the optical axis of the ray source 100 onto the side edge. Similarly, under the drive of the moving mechanism 400, an optical axis 101 of a ray emitted by the ray source 100 directly faces the other side edge of the battery 600, and the flat panel detector receives the ray penetrating through the battery 600 to obtain the corresponding initial image at the other side edge of the battery 600. It can be understood that a radiation cross section of the ray beam emitted by the ray source 100 perpendicular to the optical axis is not limited to being circular, but may also be rectangular or elliptical, for example.

The detector 200 may be, for example, an amorphous silicon flat panel detector. The ray source 100 may be, but is not limited to, an X-ray source. The moving mechanism 400 adjusts the relative positions of the carrying component 300 relative to the X-ray source and the flat panel detector in the direction parallel to the battery surface 603, such that optical axes 101 of X-rays emitted by the X-ray source are vertically projected onto the plurality of target positions on the battery surface 603. The defect detection unit 500 stitches the plurality of initial images to obtain the detection image including the entire battery 600.

It should be noted that when the detection image formed through stitching two initial images by the defect detection unit 500 has not yet obtained the detection image including the entire battery 600, a further initial image may be acquired at a target position between the two side edges of the battery 600. An acquisition sequence of the corresponding initial image at one side edge of the battery 600, the corresponding initial image at the target position between the two side edges, and the corresponding initial image at the other side edge of the battery 600 is not limited and should not be construed as a limitation to the scope of the battery defect detection device 1000 according to the embodiments of the present application. In some cases, the sequence may be adjusted. For example, the corresponding initial images at the two side edges of the battery 600 are acquired first, and then the corresponding initial image at the target position between the two side edges is acquired. Alternatively, the moving mechanism 400 may move, for example, at a constant speed under the drive of a stepping motor, and move from one side edge of the battery 600 to sequentially acquire the corresponding initial image at one side edge, the corresponding initial image at the target position between the two side edges, and the corresponding initial image at the other side edge of the battery 600.

The flat panel detector has a high spatial resolution, which can clearly display fine structures and variations and is beneficial to improving the accuracy of battery defects.

As shown in FIG. 4, according to some embodiments of the present application, the dimension of a radiation surface of the ray source 100 on a plane where the carrying surface is located is greater than a preset value.

A radiation cross section 102 of the ray source 100 perpendicular to the optical axis 101 thereof may be circular, and the radius of the radiation surface of the ray source 100 on the plane where the battery surface 603 is located may be greater than a preset value. The radiation cross section 102 of the ray source 100 perpendicular to the optical axis 101 thereof may also be rectangular, and the length and/or width of the radiation surface of the ray source 100 on the plane where the battery surface 603 is located may be greater than a preset value. In other words, the dimension of the radiation surface may be configured based on the shape of the radiation surface.

It should be noted that, for the convenience of description and understanding, the surface of the battery placed on the carrying surface is represented by the carrying surface of the carrying component in the embodiments of the present application.

It should be understood that the radiation radius of the ray source 100 on the plane where the battery surface 603 is located is greater than the preset value. For batteries 600 of different models, the preset value is related to the models of the batteries 600 and the number of captures, provided that it can be ensured that a detection image including the entire battery 600 can be obtained by stitching a plurality of captured initial images. For example, when the target positions to be captured include only two opposite side edges of the battery, the preset value may be configured to be greater than half of the height of the battery (the distance extending from one of the two opposite side edges to the other side edge), so as to ensure that the detection image including the entire battery 600 can be obtained by stitching two initial images captured at the two opposite side edges. In the embodiments of the present application, a capturing position of the ray source and the detector may refer to a capturing position onto which the optical axis of the ray source is vertically projected, such that the detector receives the ray penetrating through the battery at this point to obtain a corresponding initial image at the capturing position.

Therefore, the radiation surface of the ray source on the plane where the battery surface 603 is located is large enough, which further mitigates the problem of distortion at the edge of the battery in the captured image to improve the detection effect, and reduces the number of captures to improve the detection efficiency.

As shown in FIG. 4, according to some embodiments of the present application, the plurality of target positions include a first preset point 601 on each of two opposite side edges of the battery 600.

The moving mechanism 400 adjusts the relative positions of the carrying component 300 relative to the ray source 100 and the detector 200 in the direction parallel to the carrying surface of the battery, such that the optical axes 101 of the rays emitted by the ray source 100 are vertically projected onto the battery surface 603, respectively, and the optical axes 101 of the rays emitted by the ray source 100 are aligned with the first preset points 601 on the two opposite side edges of the battery. A plurality of initial images obtained at the first preset points 601 on the two opposite side edges of the battery are stitched to obtain the detection image including the entire battery 600.

The first preset point 601 may be, for example, a central point on the side edge of the battery 600, or a 1/3 or 1/4 division point.

Since the plurality of target positions include the first preset point 601 on each of the two opposite side edges of the battery 600, the moving mechanism 400 can move with reference to the plurality of first preset points 601, such that the problem of distortion at the edge of the battery can be solved more effectively.

As shown in FIG. 7, according to some embodiments of the present application, the plurality of target positions further include at least one second preset point 602 on a connecting line between two first preset points 601 on the two opposite side edges of the battery 600.

When the dimension of the battery 600 is large and the dimension of the radiation surface of the ray source 100 on the plane where the carrying surface of the battery is located is less than the preset value, the detection image including the entire battery 600 cannot be obtained by stitching two initial images obtained at two first preset points 601 on the two opposite side edges of the battery 600 (i.e., captured by vertically projecting the optical axis of the ray source onto the first preset points 601). The detection image including the entire battery 600 is obtained by stitching the initial image obtained at the at least one second preset point 602 with the initial images at the two first preset points 601.

For example, the number of the target positions is three, where two first preset points 601 are respectively disposed on the two opposite side edges of the battery 600, and a second preset point 602 is further disposed on the connecting line between the two first preset points 601 on the two opposite side edges of the battery 600. The detection image including the entire battery 600 is obtained by stitching a plurality of initial images obtained at the two first preset points 601 and the second preset point 602, respectively.

The second preset point 602 may be, for example, but is not limited to, a midpoint on the connecting line between the two first preset points 601. It can be understood that the second preset point 602 may alternatively not be located on the connecting line between the two first preset points 601. For example, the second preset point may be located at one side of the midpoint on the connecting line between the two first preset points 601.

Since the plurality of target positions further include the at least one second preset point 602 on the connecting line between the two first preset points 601 on the two opposite side edges of the battery 600, by obtaining the initial images at the two first preset points 601 and the at least one second preset point 602, it can be ensured that the detection image including the entire battery 600 can be obtained, thereby implementing comprehensive defect detection on the battery 600 and improving the accuracy of battery defect detection.

As shown in FIGs. 4 and 7, according to some embodiments of the present application, the first preset point 601 is a midpoint on each side edge.

The moving mechanism 400 adjusts the relative positions of the carrying component 300 relative to the ray source 100 and the detector 200, such that the optical axes 101 of the rays emitted by the ray source 100 are vertically projected onto the battery surface 603, respectively, and the optical axes 101 of the rays emitted by the ray source 100 are aligned with the midpoints on the two opposite side edges of the battery. Two initial images are obtained at the midpoints on the two opposite side edges of the battery.

When the dimension of the radiation surface of the ray source 100 on the plane where the carrying surface of the battery is located is greater than the preset value, the detection image including the entire battery 600 can be obtained based on the two initial images obtained at the midpoints on the two opposite side edges of the battery 600.

Alternatively, when the dimension of the radiation surface of the ray source 100 on the plane where the carrying surface is located is less than the preset value, the detection image including the entire battery 600 cannot be obtained by stitching the two initial images obtained at the midpoints on the two opposite side edges of the battery 600. Therefore, it is still necessary to dispose at least one second preset point 602 on the connecting line of the two midpoints, such that the detection image including the entire battery 600 can be obtained by stitching the two initial images obtained at the midpoints on the side edges and the initial image obtained at the at least one second preset point 602.

In some embodiments, the second preset point 602 may be located on the connecting line of the two midpoints.

Since the first preset point 601 is a midpoint on each of the side edges, such that the obtained initial image is symmetrical about the midpoint, which avoids the problem of distortion at one end of the side edge of the battery, thereby improving the battery defect detection efficiency, and also avoids a need for multiple captures at the side edge, which may occur if the first preset point deviates from the midpoint, to obtain the detection image including the entire battery.

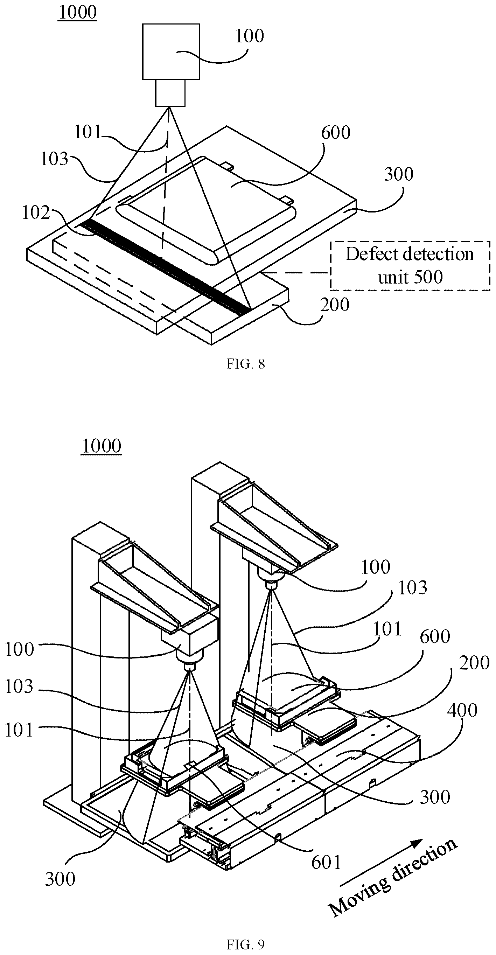

FIG. 8 is a schematic structural diagram of still another battery defect detection device according to some embodiments of the present application. The detector 200 is a time delay integration detector. As shown in FIG. 8, according to some embodiments of the present application, the detector 200 is the time delay integration detector.

The time delay integration (TDI) detector is an imaging technology similar to linear array scanning, which has high detection efficiency and can mitigate image distortion caused by irradiation angles to some extent.

According to some embodiments of the present application, when the detector 200 is the time delay integration detector, the carrying component 300 and the battery 600 can move in the direction parallel to the carrying surface of the battery under the drive of the moving mechanism 400. The optical axes 101 of the rays emitted by the ray source 100 are vertically projected onto the battery surface 603. The battery 600 may move, for example, at a constant speed under the drive of a stepping motor. The optical axis of the ray source 100 is vertically projected onto the surface of the battery 600, and the optical axis moves from one side edge (for example, a side edge perpendicular to the height direction of the battery 600) to the other opposite side edge of the surface of the battery cell in a linear array scanning manner. The time delay integration detector synchronously receives the rays penetrating through the battery 600 to obtain a plurality of initial images, and the detection image including the entire battery 600 is obtained by stitching the plurality of columns of initial images. The battery 600 moves at a constant speed during the detection and imaging of the time delay integration detector. It can be understood that the moving mechanism 400 may also drive the ray source and the detector to move synchronously, such that the surface of the battery can be scanned to obtain a plurality of initial images as well.

The detection image including the entire battery 600 is acquired by the time delay integration detector, which can better overcome the problem of image distortion at the edge of the battery and improve the quality of the detection image of the battery, thereby improving the battery defect detection effect.

According to some embodiments of the present application, the rays emitted by the ray source 100 scan the battery surface 603 in a direction parallel to a side edge of the battery 600, and the plurality of target positions include a plurality of scanning positions of the optical axis 101 of the ray source 100 on the battery surface 603.

The time delay integration detector receives the rays 103 of the radiation cross section 102, where the rays emitted by the ray source 100 scan the battery surface 603 in a direction parallel to a side edge of the battery 600 (e.g., the side edge parallel to the height direction of the battery 600).

The rays emitted by the ray source 100 continuously scan the plurality of scanning positions (i.e., target positions) on the battery surface 603, starting from when one side of the battery 600 enters the scanning region (the region where the battery is located) until the other side of the battery 600 exits the scanning region, so as to obtain a plurality of corresponding initial images at the plurality of target positions, that is, a plurality of initial images captured with the optical axis of the ray source being perpendicular to the plurality of target positions.

Scanning the battery surface by the ray source can effectively solve the problem of distortion at the edge of the battery and improve the quality of the obtained detection image of the battery, which is further beneficial to more accurate battery defect detection and improving the accuracy of detection results.

FIG. 9 is a schematic structural diagram of another battery defect detection device according to some embodiments of the present application. As shown in FIG. 9, according to some embodiments of the present application, the moving mechanism 400 is configured to drive the carrying component 300 to move in the direction parallel to the battery surface 603, so as to adjust the relative positions of the carrying component 300 relative to the ray source 100 and the detector 200.

In the battery defect detection device 1000, a plurality of carrying components 300, ray sources 100, and detectors 200 may be provided. For example, two carrying components 300, two ray sources 100, and two detectors 200 are provided in one set of battery defect detection device 1000, and the carrying components 300, the ray sources 100, and the detectors 200 are arranged in groups (see FIG. 9).

The moving mechanism 400 drives the carrying component 300 to move in the direction parallel to the battery surface 603, so as to drive the battery 600 to move to the plurality of target positions. For example, the moving mechanism 400 is a slide rail assembly, and a part of the slide rail assembly is fixed to the carrying component 300. As driven by power, the slide rail assembly drives the carrying component 300 to move in the direction parallel to the battery surface 603 (referring to the moving direction in the figure), such that the battery 600 is driven to adjust the relative positions of the carrying component 300 relative to the ray source 100 and the detector 200 by the moving mechanism 400, such that the optical axes 101 of the rays emitted by the ray source 100 are vertically projected onto the plurality of target positions on the battery surface 603.

When batteries 600 are detected, since a plurality of carrying components 300, ray sources 100, and detectors 200 may be provided, the battery defect detection device 1000 can simultaneously detect a plurality of batteries 600 located at the detection station, thereby improving the detection efficiency.

For example, the moving mechanism 400 is a pull wire for battery detection, and a moving direction of the pull wire is parallel to the battery surface 603. During operation, the pull wire drives the carrying component 300 to move to drive the battery 600 on the carrying component 300 to move, so as to adjust the relative positions of the battery 600 on the carrying component 300 relative to the ray source 100 and the detector 200, such that the optical axis of the ray source 100 becomes perpendicular to each of the plurality of target positions on the surface of the battery 600 in sequence.

The moving mechanism 400 drives the carrying component 300 to move in the direction parallel to the battery carrier, so as to adjust the relative positions of the carrying component 300 relative to the ray source 100 and the detector 200, such that the optical axis 101 of the ray emitted by the ray source 100 is vertically projected onto the battery surface 603 at each target position, thereby mitigating the problem of image distortion at the edge of the battery and improving the battery defect detection effect.

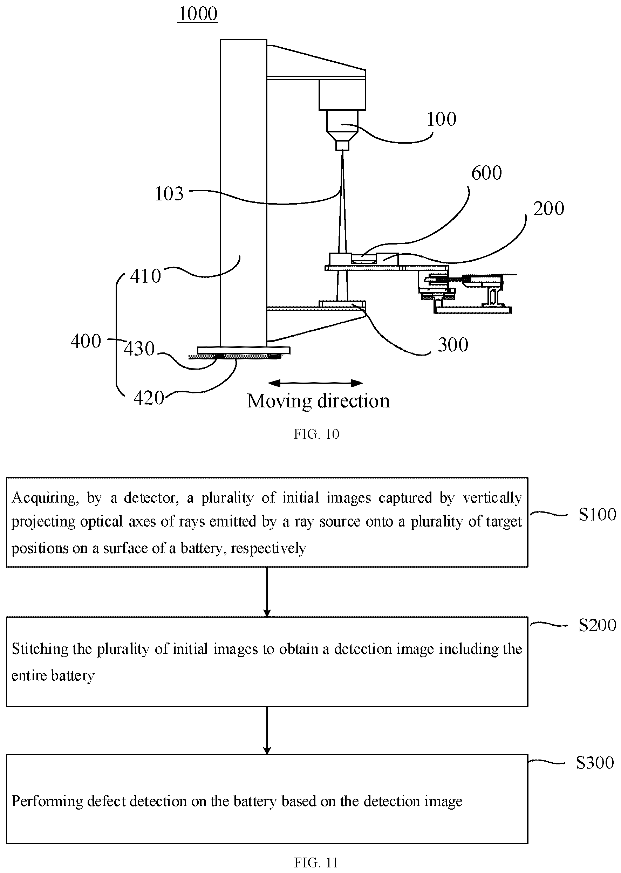

FIG. 10 is a schematic structural diagram of still another battery defect detection device according to some embodiments of the present application. As shown in FIG. 10, according to some embodiments of the present application, the moving mechanism 400 is configured to drive the ray source 100 and the detector 200 to move in the direction parallel to the carrying surface, so as to adjust the relative positions of the carrying component 300 relative to the ray source 100 and the detector 200.

According to some embodiments of the present application, the moving mechanism 400 may include a fixing support 410, a lead screw 420, and a threaded sleeve 430. The ray source 100 and the detector 200 are separately fixed on the fixing support 410. The threaded sleeve 430 is fixed below the fixing support 410. The lead screw 420 is fitted with the threaded sleeve 430. As driven by power, the lead screw 420 rotates to drive the threaded sleeve 430 and the fixing support 410 to move, so as to drive the ray source 100 and the detector 200 to move in the direction parallel to the battery surface 603 (parallel to the carrying surface).

Description is made by using an example in which the detector 200 is the time delay integration detector. When the battery 600 on the carrying surface of the carrying component 300 is placed at the detection station, the lead screw 420 is driven to rotate to drive the ray source 100 and the detector 200 to move to the left or right in the direction parallel to the battery surface 603. The rays start scanning from one side of the surface of the battery 600 until the ray source 100 and the detector 200 exit the other side of the surface of the battery 600. Therefore, during the scanning, the moving mechanism 400 drives the ray source 100 and the detector 200 to move, so as to adjust the relative positions of the carrying component 300 relative to the ray source 100 and the detector 200.

Taking the detector 200 being the flat panel detector as an example, the moving mechanism 400 drives, in the direction parallel to the battery surface 603, the ray source 100 and the detector 200 to sequentially move to a plurality of target positions on the battery surface 603 onto which the ray source is vertically projected. The detector 200 receives the rays penetrating through the battery 600 to obtain a plurality of initial images. The defect detection unit 500 stitches the plurality of initial images to obtain a detection image including the entire battery 600.

The moving mechanism 400 drives the ray source 100 and the detector 200 to move in the direction parallel to the battery surface 603, so as to adjust the relative positions of the carrying component 300 relative to the ray source 100 and the detector 200, such that the optical axis 101 of the ray emitted by the ray source 100 is vertically projected onto the battery surface 603 at each target position, thereby mitigating the problem of image distortion at the edge of the battery and improving the battery defect detection effect.

FIG. 11 is a flowchart of a battery defect detection method according to some embodiments of the present application. As shown in FIG. 11, the embodiments of the present application provide a battery defect detection method. The battery defect detection method includes:
S100: acquiring, by a detector, a plurality of initial images captured by vertically projecting optical axes of rays emitted by a ray source onto a plurality of target positions on a battery surface 603, respectively;
S200: stitching the plurality of initial images to obtain a detection image including the entire battery; and
S300: performing defect detection on the battery based on the detection image.

Referring to FIGs. 2-5, the moving mechanism 400 adjusts the relative positions of the carrying component 300 relative to the ray source 100 and the detector 200 in the direction parallel to the battery surface 603. When the optical axis 101 of the ray emitted by the ray source 100 is vertically projected onto a target position on the battery surface 603, the ray 103 emitted by the ray source 100 is vertically projected onto the target position on the surface of the battery 600, such that the detector 200 receives the ray penetrating through the battery 600 to obtain a corresponding initial image at the target position.

The stitching module 2002 stitches the plurality of initial images to obtain the detection image including the entire battery 600, and performs defect detection on the battery 600 based on the detection image, for example, performs identification on the detection image including the entire battery 600, so as to identify defects such as internal wrinkles, folded corners, and electrode plate damage of the battery.

It should be noted that, in the battery defect detection method according to the embodiments of the present application, the optical axes 101 of the rays emitted by the ray source 100 are vertically projected onto the plurality of target positions on the battery surface 603, respectively, to obtain a plurality of corresponding initial images at the plurality of target positions. The plurality of initial images are stitched to obtain the detection image including the entire battery 600, thereby reducing the risk of image distortion at the edge of the battery and improving the battery defect detection effect.

The initial images captured by vertically projecting the optical axes 101 of the rays emitted by the ray source 100 respectively onto the plurality of target positions on the battery surface 603 are acquired by the detector 200, thereby mitigating the problem of image distortion at the edge of the battery and improving the battery defect detection effect. In addition, the detection image including the entire battery 600 is obtained by stitching the plurality of initial images, such that defect detection can be performed on the entire battery 600, thereby improving the accuracy and comprehensiveness of battery defect detection.

According to some embodiments of the present application, the detector 200 is a flat panel detector, and the dimension of a radiation surface of the ray source 100 on a plane where the carrying surface is located is greater than a preset value.

A radiation cross section of the ray source 100 perpendicular to the optical axis 101 thereof may be circular, for example, and the radius of the radiation surface of the ray source 100 on the plane where the battery surface 603 is located may be greater than a preset value. The radiation cross section 102 of the ray source 100 perpendicular to the optical axis 101 thereof may also be rectangular, and the length and/or width of the radiation surface of the ray source 100 on the plane where the battery surface 603 is located may be greater than a preset value. In other words, the dimension of the radiation surface may be configured based on the shape of the radiation surface. The shape of the radiation cross section of the ray source 100 is not limited to being circular or rectangular, but may also be elliptical, for example.

It should be noted that, for the convenience of description and understanding, the surface of the battery placed on the carrying surface is represented by the carrying surface of the carrying component in the embodiments of the present application.

It should be understood that the radiation radius of the ray source 100 on the plane where the battery surface 603 is located is greater than the preset value. For batteries 600 of different models, the preset value is related to the models of the batteries 600 and the number of captures, provided that it can be ensured that a detection image including the entire battery 600 can be obtained by stitching a plurality of captured initial images. For example, when the target positions to be captured include only two opposite side edges of the battery, the preset value may be configured to be greater than half of the height of the battery, so as to ensure that the detection image including the entire battery 600 can be obtained by stitching two initial images captured at the two opposite side edges.

The dimension of the radiation surface of the ray source 100 on the plane where the carrying surface is located is greater than the preset value, which further mitigates the problem of distortion at the edge of the battery in the captured image to improve the detection effect, and reduces the number of captures to improve the detection efficiency.

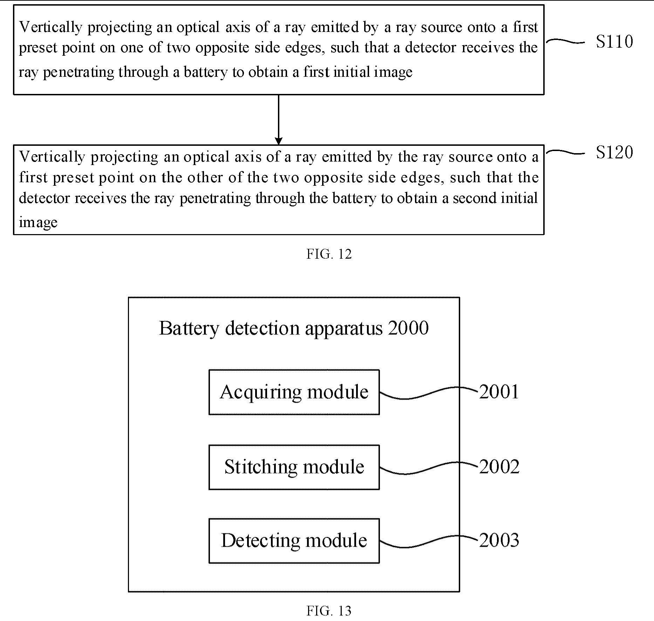

FIG. 12 is a flowchart of another battery defect detection method according to some embodiments of the present application. As shown in FIG. 12, according to some embodiments of the present application, the plurality of target positions include a first preset point on each of two opposite side edges of the battery, the plurality of initial images include a first initial image and a second initial image, and the first initial image and the second initial image are captured by using the following method:
S110: vertically projecting an optical axis of a ray emitted by the ray source onto the first preset point on one of the two opposite side edges, such that the detector receives the ray penetrating through the battery to obtain the first initial image; and
S120: vertically projecting an optical axis of a ray emitted by the ray source onto the first preset point on the other of the two opposite side edges, such that the detector receives the ray penetrating through the battery to obtain the second initial image.

Referring to FIGs. 2-5, the moving mechanism 400 adjusts the relative positions of the carrying component 300 relative to the ray source 100 and the detector 200 in the direction parallel to the battery surface 603, such that the optical axes 101 of the rays emitted by the ray source 100 are vertically projected onto the plurality of target positions on the battery surface 603, respectively, and the plurality of target positions include the first preset point 601 on each of the two opposite side edges of the battery aligned with the optical axis 101 of the ray emitted by the ray source 100.

For example, the optical axis 101 of the ray emitted by the ray source 100 is vertically aligned with the first preset point 601 on one of the side edges of the battery 600, and the ray 103 forms a circular radiation cross section 102 at the first preset point 601, such that the detector 200 receives the ray penetrating through the battery 600 to obtain the first initial image. The moving mechanism 400 adjusts the relative positions of the carrying component 300 relative to the ray source 100 and the detector 200, such that the optical axis 101 of the ray emitted by the ray source 100 is vertically projected onto the first preset point 601 on the other of the two opposite side edges, such that the detector 200 receives the ray penetrating through the battery 600 to obtain the second initial image.

Since the plurality of target positions include the first preset point 601 on each of the two opposite side edges of the battery 600, the problem of distortion at the edge of the battery can be solved more effectively.

According to some embodiments of the present application, the plurality of target positions include at least one second preset point 602 on a connecting line between two first preset points 601 on the two opposite side edges of the battery 600, the plurality of initial images include at least one third initial image, and the at least one third initial image is captured by using the following method:
vertically projecting an optical axis 101 of a ray emitted by the ray source 100 onto each of the at least one second preset point, respectively, such that the detector 200 receives the ray penetrating through the battery 600 to obtain the third initial image.

For example, when the dimension of the battery is large and the radiation radius of the ray source 100 on the plane where the battery surface 603 is located is less than a preset value, the detection image including the entire battery 600 cannot be obtained by stitching two initial images obtained by vertically projecting the optical axis of the ray source onto the two first preset points 601 on the two opposite side edges of the battery 600. Therefore, at least one second preset point 602 may be added to a middle region on the battery surface 603, so as to obtain the corresponding third initial image at the at least one second preset point 602, such that the detection image including the entire battery 600 can be obtained by stitching the plurality of captured initial images.

In some embodiments, the optical axis 101 of the ray emitted by the ray source 100 is vertically projected onto each of the at least one second preset point 602, respectively, such that the detector 200 receives the ray penetrating through the battery 600 to obtain the third initial image. The detection image including the entire battery 600 is obtained by stitching the plurality of initial images captured at the plurality of first preset points 601 and the second preset point 602.

By obtaining the initial images at the two first preset points 601 and the at least one second preset point 602, it can be ensured that the detection image including the entire battery 600 can be obtained, thereby implementing comprehensive defect detection on the battery 600 and improving the accuracy of battery defect detection.

According to some embodiments of the present application, the detector 200 is the time delay integration detector, and the plurality of initial images being captured by using the following method includes:
scanning the battery surface 603 by the rays emitted by the ray source 100 in a direction parallel to a side edge of the battery 600, such that the detector 200 receives the rays penetrating through the battery 600 to obtain the plurality of initial images, where the plurality of target positions include a plurality of scanning positions of the optical axis 101 of the ray source 100 on the battery surface 603.

According to some embodiments of the present application, when the detector 200 is the time delay integration detector, the carrying component 300 and the battery 600 can move in the direction parallel to the carrying surface of the battery under the drive of the moving mechanism 400. The optical axes 101 of the rays emitted by the ray source 100 are vertically projected onto the battery surface 603. The battery 600 may move, for example, at a constant speed under the drive of a stepping motor. The optical axis of the ray source 100 is vertically projected onto the surface of the battery 600, and the optical axis moves from one side edge (for example, a side edge perpendicular to the height direction of the battery 600) to the other opposite side edge of the surface of the battery cell in a linear array scanning manner. The time delay integration detector synchronously receives the rays penetrating through the battery 600 to obtain a plurality of initial images, and the detection image including the entire battery 600 is obtained by stitching the plurality of columns of initial images. The battery 600 moves at a constant speed during the detection and imaging of the time delay integration detector. It can be understood that the moving mechanism 400 may also drive the ray source and the detector to move synchronously, such that the surface of the battery can be scanned to obtain a plurality of initial images as well.

The detection image including the entire battery is acquired by the time delay integration detector, which can better overcome the problem of image distortion at the edge of the battery and improve the quality of the detection image of the battery, thereby improving the battery defect detection effect.

According to some embodiments of the present application, the battery defect detection method further includes:
rejecting or retesting the battery in response to a failure in a detection result of the battery.

During battery defect detection, there may be a case where the accuracy of the detection result is affected due to an improper operation or an accidental device failure. In this case, the battery with a failure in the detection result may be retested, thereby reducing the risk of misjudgment caused by accidental factors (device failures and improper operations).

Alternatively, the battery 600 with a failure in the detection result may be rejected, so as to improve the reliability and detection efficiency of the battery 600.

The battery 600 with a failure in the detection result is rejected or retested, thereby improving the accuracy of battery defect detection.

FIG. 13 is a block diagram illustrating the composition of a battery defect detection apparatus according to some embodiments of the present application. As shown in FIG. 13, the embodiments of the present application provide a battery defect detection apparatus 2000. The battery defect detection apparatus 2000 includes an acquiring module 2001, a stitching module 2002, and a detecting module 2003. The acquiring module 2001 is configured to acquire a plurality of initial images captured by vertically projecting optical axes of rays emitted by a ray source onto a plurality of target positions on a battery surface 603, respectively. The stitching module 2002 is configured to stitch the plurality of initial images to obtain a detection image including the entire battery. The detecting module 2003 is configured to perform defect detection on the battery based on the detection image.

Referring to FIGs. 2-5, when the optical axis 101 of the ray emitted by the ray source 100 is vertically projected onto the target position on the battery surface 603, the ray 103 emitted by the ray source 100 is projected onto the battery 600, such that the detector 200 receives the ray penetrating through the battery 600. The acquiring module 2001 acquires the plurality of initial images captured by vertically projecting the optical axes 101 of the rays emitted by the ray source 100 onto the plurality of target positions on the battery surface 603, respectively. The stitching module 2002 stitches the plurality of initial images to obtain the detection image including the entire battery 600. The detecting module 2003 is configured to perform defect detection on the battery 600 based on the detection image, for example, perform identification on the detection image including the entire battery 600, so as to identify defects such as internal wrinkles, folded corners, and electrode plate damage of the battery.

The detection image is obtained based on the plurality of initial images captured by vertically projecting the optical axes of the rays emitted by the ray source onto the plurality of target positions on the battery surface, respectively, thereby mitigating the problem of image distortion at the edge of the battery and improving the battery defect detection effect. In addition, the detection image including the entire battery is obtained by stitching the plurality of initial images, such that defect detection can be performed on the entire battery, thereby improving the accuracy and comprehensiveness of battery defect detection.

Some embodiments of the present application provide a battery production system. The battery production system includes the battery detection device according to the foregoing embodiments. It can be understood that, in addition to the battery detection device, the battery production system may further include a winding device, a liquid injection device, a formation device, and the like.

Some embodiments of the present application provide an electronic device. The electronic device includes at least one processor; and a memory communicatively connected to the at least one processor, where the memory stores instructions executable by the at least one processor, and the instructions, when executed by the at least one processor, enable the at least one processor to perform the battery defect detection method according to the foregoing embodiments.

Some embodiments of the present application provide a computer-readable storage medium. The computer-readable storage medium stores a computer program that, when executed by a processor, implements the battery defect detection method according to the foregoing embodiments.

Some embodiments of the present application provide a computer program product. The computer program product includes a computer program that, when executed by a processor, implements the battery defect detection method according to the foregoing embodiments.

In order to better understand the battery defect detection method and detection device 1000 according to the embodiments of the present application, detailed descriptions are given below with the detector 200 being a flat panel detector and a TDI detector, separately.

(i) When the detector 200 is the flat panel detector, as shown in FIG. 2, the optical axis of the ray source 100 is aligned with a midpoint on one side edge of the battery 600 for a first capture. For example, the moving mechanism drives the mobile ray source 10 and detector 200 to move in the height direction of the battery, or the moving mechanism drives the carrying component 300 to move in the height direction of the battery to drive the battery 600 to move, such that the optical axis 101 of the ray emitted by the ray source 100 can be vertically projected onto a target position on the battery surface 603.

Then, the optical axis of the ray source 100 is aligned with a midpoint on the other opposite side edge of the battery 600 for a second capture. For example, after the first capture is completed, the moving mechanism drives the mobile ray source 10 and detector to move in the height direction of the battery again, or the moving mechanism drives the carrying component 300 to move in the height direction of the battery to drive the battery 600 to move, such that the optical axis of the ray source 100 is aligned with the midpoint on the other side edge of the battery for the second capture.

By configuring the radius of the radiation surface of the ray source 100 on the plane where the battery surface 603 is located to be greater than half of the height of the battery, a detection image formed by stitching two captured initial images can include the entire battery, such that defect detection can be performed on the entire battery.

After each of the two captures is completed, algorithmic identification is performed to identify whether the image contains defects such as wrinkled, folded, or damaged electrode plates. After the identification is completed, the resulting images are displayed separately, or the pictures are displayed in a combined manner with overlapping sections cropped out; or the original images are cropped and stitched before algorithmic identification, and then the resulting images are displayed. For example, the first captured initial image is stitched with the second captured image firstly, and then algorithmic identification is performed on the detection image formed by stitching, to detect battery defects. Alternatively, algorithmic identification is firstly performed on the first captured initial image and the second captured image, separately, to detect battery defects. After the detection is completed, the initial images are stitched to form a detection image, and a detection result is output.

It should be noted that, during the first and second captures, the optical axes 101 of the rays emitted by the ray source 100 are vertically projected onto a plurality of target positions on the battery surface, respectively, thereby reducing the risk of distortion at the edge of the battery.

(ii) When the detector 200 is the TDI detector, as shown in FIG. 8, the optical axis of the ray source 100 is always perpendicular to the surface of the battery 600 for linear scanning. During the linear scanning, a plurality of initial images are acquired by the TDI detector, thereby mitigating the problem of image distortion at the edge of the battery.

The moving direction of the battery may be parallel to the height direction of the battery. The moving mechanism drives the carrying component to move linearly at a constant speed in the height direction of the battery to drive the battery 600 to move synchronously. When the battery 600 enters a detection region of the TDI detector, the TDI detector starts detection, which continues until the entire battery completely exits the detection region.

Finally, it should be noted that the above embodiments are only used to illustrate the technical solutions of the present application, rather than limit same. Although the present application has been described in detail with reference to the foregoing embodiments, those of ordinary skill in the art should understand that modifications can still be made to the technical solutions recorded in the foregoing embodiments, or equivalent substitutions to some or all of the technical features can be made. However, such modifications or substitutions do not make the spirit of the corresponding technical solutions deviate from the scope of the technical solutions in the embodiments of the present application, and shall all fall within the scope of claims and specification of the present application. In particular, the technical features mentioned in the embodiments can be combined in any manner, provided that there is no structural conflict. The present application is not limited to the specific embodiments disclosed herein but includes all the technical solutions that fall within the scope of the claims.

## Claims

1. A battery defect detection device, comprising:
a ray source;
a detector;
a carrying component comprising a carrying surface configured to carry a battery;
a moving mechanism configured to adjust, in a direction parallel to the carrying surface, relative positions of the carrying component relative to the ray source and the detector, such that optical axes of rays emitted by the ray source are vertically projected onto a plurality of target positions on a battery surface, respectively, and the detector receives the rays penetrating through the battery to obtain a plurality of initial images; and
a defect detection unit connected to the detector, wherein the defect detection unit is configured to stitch the plurality of initial images to obtain a detection image comprising the entire battery, and to perform defect detection on the battery based on the detection image.

2. The battery defect detection device according to claim 1, wherein the detector is a flat panel detector.

3. The battery defect detection device according to claim 2, wherein a dimension of a radiation surface of the ray source on a plane where the carrying surface is located is greater than a preset value.

4. The battery defect detection device according to claim 2 or 3, wherein the plurality of target positions comprise a first preset point on each of two opposite side edges of the battery.

5. The battery defect detection device according to claim 4, wherein the plurality of target positions further comprise at least one second preset point on a connecting line between two of the first preset points on the two opposite side edges of the battery.

6. The battery defect detection device according to claim 4, wherein the first preset point is a midpoint on each of the side edges.

7. The battery defect detection device according to claim 1, wherein the detector is a time delay integration detector.

8. The battery defect detection device according to claim 7, wherein the rays emitted by the ray source scan the battery surface in a direction parallel to a side edge of the battery, and the plurality of target positions comprise a plurality of scanning positions of an optical axis of the ray source on the battery surface.

9. The battery defect detection device according to any one of claims 1 to 8, wherein the moving mechanism is configured to drive the carrying component to move in the direction parallel to the carrying surface, so as to adjust the relative positions of the carrying component relative to the ray source and the detector.

10. The battery defect detection device according to any one of claims 1 to 8, wherein the moving mechanism is configured to drive the ray source and the detector to move in the direction parallel to the carrying surface, so as to adjust the relative positions of the carrying component relative to the ray source and the detector.

11. A battery defect detection method, comprising:
acquiring, by a detector, a plurality of initial images captured by vertically projecting optical axes of rays emitted by a ray source onto a plurality of target positions on a battery surface, respectively;
stitching the plurality of initial images to obtain a detection image comprising the entire battery; and
performing defect detection on the battery based on the detection image.

12. The battery defect detection method according to claim 11, wherein the detector is a flat panel detector, and a dimension of a radiation surface of the ray source on a plane where the carrying surface is located is greater than a preset value.

13. The battery defect detection method according to claim 12, wherein the plurality of target positions comprise a first preset point on each of two opposite side edges of the battery, the plurality of initial images comprise a first initial image and a second initial image, and the first initial image and the second initial image are captured by using the following method:
vertically projecting an optical axis of a ray emitted by the ray source onto the first preset point on one of the two opposite side edges, such that the detector receives the ray penetrating through the battery to obtain the first initial image; and
vertically projecting an optical axis of a ray emitted by the ray source onto the first preset point on the other of the two opposite side edges, such that the detector receives the ray penetrating through the battery to obtain the second initial image.

14. The battery defect detection method according to claim 13, wherein the plurality of target positions comprise at least one second preset point on a connecting line between two of the first preset points on the two opposite side edges of the battery, the plurality of initial images comprise at least one third initial image, and the at least one third initial image is captured by using the following method:
vertically projecting an optical axis of a ray emitted by the ray source onto each of the at least one second preset point, respectively, such that the detector receives the ray penetrating through the battery to obtain the third initial image.

15. The battery defect detection method according to claim 11, wherein the detector is a time delay integration detector, and the plurality of initial images being captured by using the following method comprises:
scanning the battery surface by the rays emitted by the ray source in a direction parallel to a side edge of the battery, such that the detector receives the rays penetrating through the battery to obtain the plurality of initial images, wherein the plurality of target positions comprise a plurality of scanning positions of an optical axis of the ray source on the battery surface.

16. The defect detection method according to any one of claims 11 to 15, wherein the battery defect detection method further comprises:
rejecting or retesting the battery in response to a failure in a detection result of the battery.

17. A battery defect detection apparatus, the apparatus comprising:
an acquiring module configured to acquire a plurality of initial images captured by vertically projecting optical axes of rays emitted by a ray source onto a plurality of target positions on a battery surface, respectively;
a stitching module configured to stitch the plurality of initial images to obtain a detection image comprising the entire battery; and
a detecting module configured to perform defect detection on the battery based on the detection image.

18. A battery production system, comprising the battery detection device according to any one of claims 1 to 10.

19. An electronic device, the electronic device comprising:
at least one processor; and
a memory communicatively connected to the at least one processor,
wherein the memory stores instructions executable by the at least one processor, and the instructions, when executed by the at least one processor, enable the at least one processor to perform the battery defect detection method according to any one of claims 11 to 16.

20. A computer-readable storage medium, storing a computer program that, when executed by a processor, implements the battery defect detection method according to any one of claims 11 to 16.

21. A computer program product, comprising a computer program that, when executed by a processor, implements the battery defect detection method according to any one of claims 11 to 16.
